# EUROPÄISCHE PATENTSCHRIFT

(11) **EP 2 300 745 B1**
(45) Veröffentlichungstag und Bekanntmachung des Hinweises auf die Patenterteilung: **06.05.2015**
(21) Anmeldenummer: 09765611.0
(22) Anmeldetag: 17.06.2009
(51) Int. Cl.: F21K 99/00, F21V 29/00

(54) **LEUCHTELEMENT MIT KUNSTSTOFFHALTERUNG**
ILLUMINATION ELEMENT HAVING A PLASTIC SUPPORT
ELÉMENT D ÉCLAIRAGE À FIXATION PLASTIQUE

(30) Priorität: 18.06.2008 DE 102008028611
(43) Veröffentlichungstag der Anmeldung: 30.03.2011
(73) Patentinhaber: Phoenix Contact GmbH & Co. KG, 32825 Blomberg (DE)
(72) Erfinder: KALHOFF, Johannes, 32825 Blomberg (DE)
(74) Vertreter: BSB Intellectual Property Law
(86) Internationale Anmeldenummer: PCT/EP2009/004363
(87) Internationale Veröffentlichungsnummer: WO 2009/153031

(56) Entgegenhaltungen:
- EP-A- 1 691 130
- EP-A- 2 020 567
- US-A1- 2006 274 529

## Beschreibung

Die vorliegende Erfindung bezieht sich auf ein Leuchtelement. Aus dem Stand der Technik ist eine Vielzahl von Leuchtelementen bekannt. Neben den seit langen existierenden Glühbirnen setzen sich insbesondere auch in jüngerer Zeit Leuchtdioden (LED) als Beleuchtungsmittel durch. Derartige Leuchtdioden sind im Vergleich zu beispielsweise Glühbirnen effektiv im Energieverbrauch, kleiner und weisen eine geringere Wärmeentwicklung auf. In jüngerer Zeit wird daran gearbeitet, LEDs mit der Leuchtkraft von Standardleuchtmitteln zu entwickeln.

Derartige Leuchtmittel sind bereits in der Gebäudeakzentbeleuchtung und als Fahrlicht für Fahrzeuge bekannt. Allerdings sind derzeit noch keine standardisierten Lösungen für eine Kombination aus LED-Leuchtmitteln und Standardlampenfassungen bekannt. Lediglich werden derzeit standardisierte Fassungen für herkömmliche Leuchtmittel angeboten.

LED-Beleuchtungselemente sollen künftig auch in anderer Form verwendet werden. So sind beispielsweise so genannte OLEDs (organic light emmiting diode) und andere Technologien in Vorbereitung. Weiterhin ist zu erwarten, dass sich die Beleuchtung stark verändern wird.

Neben den derzeitigen Anwendungen werden auch Akzentbeleuchtungen, flächige, mobile und angesteuerte Beleuchtungen (z. B. bei Stimmungslicht) die Lichtgestaltung erweitern. Dies wiederum wird sich direkt auf den Einbau d. h. insbesondere die Abmaße, den Ort, die Stabilität und die Temperatur und die Kontaktierung zur Ansteuerung, d. h. den Stromanschluss, auswirken.

Insbesondere bei Baugruppen mit einer Vielzahl von Lichtquellen tritt dabei das Problem einer effizienten Wärmeabführung auf. So soll beispielsweise die durch eine Elektronik erzeugte Wärme besser aus dem Gehäuse abgeleitet werden.

Die EP 1 691 130 A1 zeigt eine LED Lichtquelle, die ein Gehäuse aufweist, das aus einem wärmeleitfähigen Kunststoff gefertigt sein kann. Das Gehäuse soll dazu geeignet sein, die Wärme von der Lichtquelle abzuführen. Durch die spezielle Bauform der Lichtquelle, insbesondere durch die bevorzugte Verwendung von Kühlrippen, ist der Einsatzbereich solcher Lichtquellen allerdings beschränkt.

Die US 2006/0274529 A1 offenbart einen Lampenkörper mit einem Gehäuse zur Aufnahme eines Leuchtmittel und zusätzlichen Komponente. Das Gehäuse kann aus einem wärmeleitfähigen Kunststoff gefertigt sein. Auch hier ist der Einsatzbereich durch die spezielle Bauform beschränkt.

Der vorliegenden Erfindung liegt daher die Aufgabe zugrunde, die derzeit verwendeten aufwändigen Kühlkörper zu vermeiden, zu eliminieren oder wenigstens die Wärmeverteilung besser zu steuern.

Die bisher bekannten Verfahren zur Erzeugung von Licht gehen üblicherweise einher mit einer hohen Wärmeerzeugung und die bekannten Beleuchtungsmittel gehen davon aus, dass das Leuchtmittel und deren Fassung hohe Temperaturen aufnimmt, sodass der Prozess der Lichterzeugung robust gegen Wärme sein muss.

Für LEDs oder ähnliche Verfahren gilt hingegen, dass Wärme punktuell erzeugt wird und einen Einfluss auf den Lichterzeugungsprozess und die Lebensdauer selbst hat. Weiterhin wird künftig die Bauart der Leuchtmittel kleiner und es sollen zukünftig auch andere Nutzungsarten ermöglicht werden. In diesem Falle ist die Kombination aus Wärmeabfuhranschluss und Formgebung ausschlaggebend.

Zusätzlich werden elektronische Steuerungselemente mit integriert, die ebenfalls Wärme abgeben, wie z.B. Dimmer, Farbsteuerungselemente, Lichtregelelemente etc.

Derzeit konzentrieren sich die meisten Hersteller von LEDs auf die Aufgabe, Licht aus LEDs zu erzeugen und weniger auf eine kostengünstige Herstellung von Lampenfassungen und die Anforderungen, eine Prozesswärme der LED, bei der es sich um eine stark punktuelle Wärmeentwicklung handelt, an die Umgebung abgeben zu können.

Der Erfindung liegt daher insbesondere die weitere Aufgabe zugrunde, eine spezielle Vorrichtung zur Verfügung zu stellen, welche insbesondere auch bei dem Einsatz von LEDs eine effiziente Wärmeabführung erlaubt. So sollen vorzugsweise auch Leuchtelemente herstellbar sein, welche eine Vielzahl von Lichtquellen aufweisen.

Dies wird erfindungsgemäß durch ein Leuchtelement mit den Merkmalen des Anspruchs 1 und durch eine Halterung mit den Merkmalen des Anspruchs 11 erreicht. Vorteilhafte Ausführungsformen und Weiterbildungen sind Gegenstand der Unteransprüche. Weitere bevorzugte Merkmale der Erfindung werden in den Ausführungsbeispielen angegeben.

Ein erfindungsgemäßes Leuchtelement weist wenigstens eine Lichtquelle mit zwei Anschlüssen auf, um die Lichtquelle mit elektrischem Strom zu versorgen. Weiterhin weist das Leuchtelement eine Halterung zur Aufnahme der Lichtquelle auf. Erfindungsgemäß weist die Lichtquelle einen wärmeerzeugenden Abschnitt auf und die Halterung kontaktiert diesen wärmeerzeugenden Abschnitt, wobei die Halterung aus einem thermisch leitenden Kunststoff besteht bzw. einen solchen aufweist und derart gestaltet ist, dass sie die von der Lichtquelle erzeugte Wärme wenigstens teilweise in einer bevorzugten Wärmeleitrichtung seitlich nach außen abführt. Weiterhin weist das Leuchtelement eine Fassung auf, welche die Halterung umgibt.

Vorzugsweise handelt es sich bei dieser Halterung um ein Spritzgussteil. Dabei wird bevorzugt diese Halterung bzw. deren Kunststoff in eine spezielle Form gegossen und eine spezielle Anschlusstechnik bereitgestellt. Auf diese Weise können industrielle Leuchtmittelsockel hergestellt werden.

Damit wird zur Lösung der oben beschriebenen Aufgabe ein thermisch leitender Kunststoff eingesetzt bzw. zur Verfügung gestellt, der die erzeugte Wärme an der Quelle aufnimmt und direkt an die Umgebung bzw. eine Fassung abgibt. Vorzugsweise wird daher dieses Halte- und Kühlsystem der Lichtquelle mit einer Fassung kombiniert und stellt in dieser Form bereits eine Kühleinrichtung dar. Somit ist es möglich, auch größere Wärmeleistungen über die Halterung bzw. über eine diese umgebende Fassung abzugeben.

In allen Ausgestaltungen und Weiterbildungen ist der Einsatz von thermisch und/oder elektrisch und/oder magnetisch leitenden Kunststoffen bevorzugt, bei denen z.B. feine oder sehr feine Metall-, Stahl- oder Edelstahlfasern in den Kunststoff integriert sind, sodass ein Kunststoffverbund (Compound) entsteht, der das fertige Produkt thermisch und elektrisch leitfähig macht.

Besonders bevorzugt ist auch der Einsatz sphärischer Metallteilchen, die in den Kunststoff eingelagert werden. Dabei sind Durchmesser im Mikrometerbereich bevorzugt.

Bevorzugterweise werden Metalle eingesetzt, die eine hohe thermische Leitfähigkeit haben. Beispielsweise ist der Einsatz von Kupfer oder Kupferlegierungen bevorzugt. Metallfasern oder Metallpartikel dienen als effizientes Füllmaterial für thermisch leitende Kunststoffe geradezu ideal. Trotz ihres kleinen Volumens können sie völlig ausreichen, um die thermischen Eigenschaften der Halterung ganz erheblich zu verbessern.

Besonders bevorzugt sind Einlagerungen aus Kupfer, Aluminium, sowie Bornitrid oder Graphit, um die thermische Leitfähigkeit zu erhöhen. Der Anteil an Zusatzprodukt bzw. der Füllanteil liegt insbesondere bei Werten zwischen etwa 10 und 70%, vorzugsweise zwischen etwa 20 und 60%. Die Wärmeleitfähigkeit bei Zugabe von z.B. Graphiteilchen oder Kupferpartikeln ist insbesondere größer als 1 W/(mK) und vorzugsweise größer als 2 W/(mK). Vorteilhafterweise liegt die Wärmeleitfähigkeit in einem Bereich zwischen etwa 2 W/(mK) und etwa 10 W/(mK), kann aber auch noch darüber liegen.

In allen Ausgestaltungen kann die Halterung aus Kunststoff eine dreidimensionale Materialstruktur derart aufweisen, dass neben elektrisch isolierenden Bereichen auch elektrisch leitende Bereiche vorgesehen sind, die mit Leiterbahnen ausgestattet sind. Die Herstellung kann z.B. über eine Laserstrukturierung erfolgen. Eine nachfolgende Galvanisierung stellt die elektrische Leitfähigkeit her.

Bei einer Laserstrukturierung kann ein Laser die auf der Kunststoffoberfläche und die im Material enthaltenen Metallkeime bearbeiten und aktivieren. Das Metall wird frei und setzt sich an der Oberfläche ab. Auf diese Art können feine und feinste Leitungsmuster in den Werkstoff per Laser eingebracht werden. In einem sich dann daran anschließenden Kupfer-Bad können die eigentlichen Leiterbahnen erzeugt werden, denn die Metalle aus dem Kupfer-Bad lagern sich dort ab, wo der Laser das Metall freigesetzt hat.

Insgesamt ist so die Herstellung einer anisotropen Struktur möglich, bei der bevorzugte Wärmeleitrichtungen möglich sind und bei der gezielte elektrische Verbindungen herstellbar sind. Bevorzugt handelt es sich bei der Lichtquelle um eine Leuchtdiode bzw. eine OLED.

Bei einer weiteren vorteilhaften Ausführungsform umgibt die Halterung die Lichtquelle in einer Umfangsrichtung vollständig oder doch im Wesentlichen vollständig. Auf diese Weise kann die entstehende Wärmeentwicklung allseitig abgeführt werden. So ist es möglich, dass die Halterung eine Öffnung aufweist, in welche die LED bzw. wenigstens deren wärmeentwickelnder Bereich eingesetzt wird.

Bei einer weiteren vorteilhaften Ausführungsform weist das Leuchtelement eine Fassung auf, welche die Halterung umgibt. Dabei ist es beispielsweise möglich, dass die Halterung ein Gewinde aufweist, welches in diese Fassung einschraubbar ist. Es sind jedoch auch steckbare Fassungen und dergleichen denkbar. Auf diese Weise kann entstehende Wärme auch über die Fassung abgegeben werden.

Bei einer weiteren vorteilhaften Ausführungsform weist wenigstens ein Anschluss einen elektrisch leitenden Kunststoff auf. So wäre es beispielsweise möglich, den Anschluss in die Halterung zu integrieren.

Bei einer weiteren vorteilhaften Ausführungsform besteht die Halterung teilweise aus einem elektrisch leitenden Kunststoff. So kann die elektrische Kontaktierung der Lichtquelle mit Energiezuführung als elektrischer leitender Kunststoff mit in das Design des Leuchtmittels und der Fassung integriert werden. Damit erfolgt hier vorzugsweise der elektrische Anschluss über den integrierten leitenden Kunststoff.

Die Halterung der Lichtquelle und die Fassung können vorzugsweise mit wenigstens einem elektrisch und thermisch leitenden Kunststoff optimiert werden.

Alternativ zu thermisch leitenden Kunststoffen können auch andere Materialien mit thermischen Eigenschaften, wie beispielsweise Keramik und Metall, genutzt werden. Bei einer weiteren vorteilhaften Ausführungsform weist das Leuchtelement eine weitere Kühleinrichtung auf, welche die Halterung umgibt. Vorzugsweise umgibt diese weitere Kühleinrichtung auch die oben erwähnte Fassung. Auf diese Weise ist eine noch effizientere Abführung von Wärmeleistung möglich, was insbesondere dann bedeutsam ist, wenn mehrere Lichtquellen in einem Träger angeordnet sind.

Bei einer weiteren vorteilhaften Ausführungsform weist das Leuchtelement aufgedruckte Leiterbahnen auf. Daneben können jedoch auch elektrisch leitende Eigenschaften mittels galvanischen Prozessen aufgebracht werden.

Gemäß noch einer vorteilhaften Ausführungsform weist das Leuchtelement eine Vielzahl von Lichtquellen auf. Diese Lichtquellen können dabei beispielsweise nebeneinander oder auch in einem Array oder auf der Ebene eines Rings und dergleichen angeordnet sein.

In einer vorteilhaften Weiterbildung der Erfindung weist das Leuchtelement eine Vielzahl von Halterungen auf, die an ihren Außenwandungen zusammenfügbar sind, wobei jeweils eine erste Außenwandung dieser Halterung ein erstes Profil und jeweils eine zweite Außenwandung dieser Halterung ein zweites Profil aufweist und das erste Profil und das zweite Profil komplementär zueinander ausgebildet sind. Auf diese Weise ist es möglich, eine Vielzahl von Halterungen puzzleartig zusammenzustecken. Dabei können entsprechende Leiterbahnen aufgedruckt, laminiert, aufgepresst, in die Oberfläche eingebunden, als Polymer ausgeführt oder dergleichen sein.

Die vorliegende Erfindung ist weiterhin auf eine Halterung für eine Lichtquelle gerichtet, die eine Aufnahmeausnehmung zur Aufnahme eines wärmeerzeugenden Abschnitts einer Lichtquelle aufweist, wobei die Halterung aus einem thermisch leitenden Kunststoff besteht und derart gestaltet ist, dass sie die von der Lichtquelle erzeugte Wärme wenigstens teilweise in einer bevorzugten Wärmeleitrichtung seitlich nach außen abführt.

Ein Ausführungsbeispiel der Erfindung ist in den Figuren rein schematisch dargestellt und wird nachfolgend näher beschrieben.

In den Figuren zeigen:
- Fig. 1: ein Leuchtelement nach dem Stand der Technik;
- Fig. 2: ein erfindungsgemäßes Leuchtelement in einer ersten Ausführungsform;
- Fig. 3: ein erfindungsgemäßes Leuchtelement in einer zweiten Ausführungsform in einer Vielzahl von Leuchtelement; und
- Fig. 4: ein erfindungsgemäßes Leuchtelement in einer dritten Ausführungsform.

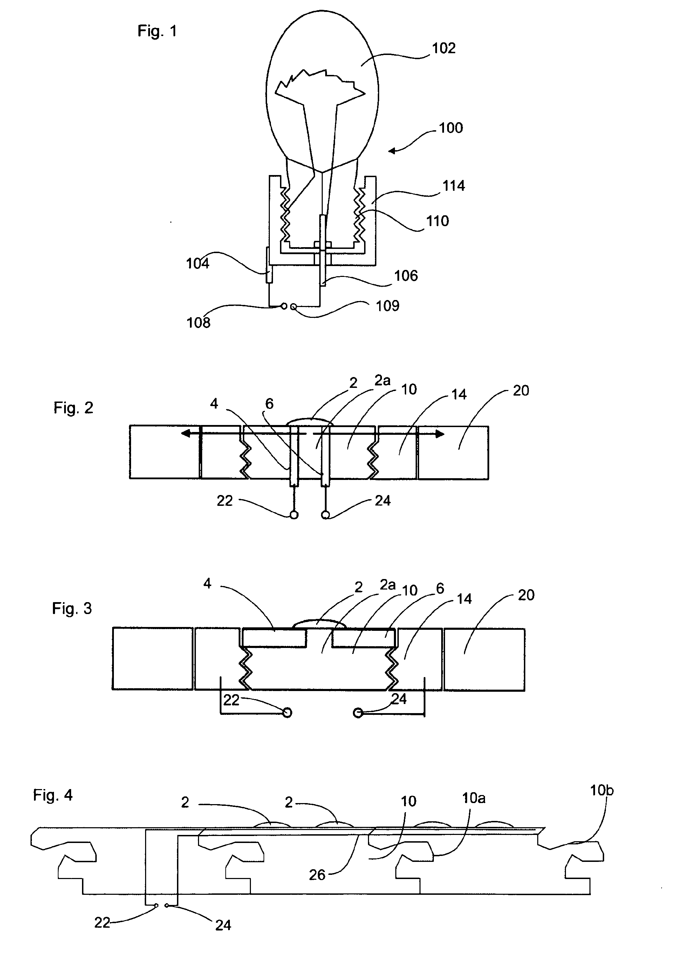

Mit Bezug auf die Figuren 1 bis 4 werden im Folgenden drei Ausführungsbeispiele eines erfindungsgemäßen Leuchtelements 100 erläutert.

Figur 1 zeigt ein Leuchtelement 100 in Form einer Glühbirne im Stand der Technik. Dabei bezieht sich das Bezugszeichen 102 auf die eigentliche Lichtquelle d. h. üblicherweise den Glaskolben mit Glühwendel.

Das Bezugszeichen 110 bezieht sich auf eine Halterung, in der die Lichtquelle 102 gehalten ist, wobei innerhalb dieser Halterung 110 auch die Stromzuführung für die Lichtquelle 102 angeordnet ist.

Die Halterung 110 wiederum ist über ein Schräubgewinde in eine Fassung 114 eingesetzt. Die Bezugszeichen 104 und 106 beziehen sich auf zwei Anschlüsse bzw. Kontakte, um das Leuchtmittel über elektrische Verbindungen 108 und 109 mit Strom zu versorgen.

Man erkennt, dass die Wärmeentwicklung bei diesem Leuchtmittel im Wesentlichen an der Lichtquelle selbst entsteht und zumindest nicht direkt an die Fassung abgegeben werden kann. Damit dient der Sockel 114 im Falle dieser Glühbirne nicht zu deren Kühlung und muss hohe Temperaturen verkraften können.

Figur 2 zeigt ein erfindungsgemäßes Leuchtelement 1. Dieses Leuchtelement 1 weist eine Lichtquelle 2 in Form einer Leuchtdiode auf, die von zwei Anschlüssen 4 und 6 mit Strom versorgt wird. Dabei entsteht in dem Bereich 2a der Lichtquelle Wärme.

Das Bezugszeichen 10 bezieht sich auf eine Halterung, welche die Lichtquelle in Umfangsrichtung vollständig umgibt und damit gut geeignet ist, die entstehende Wärmeenergie aufzunehmen und wiederum an die Umgebung anzugeben.

Die Halterung 10 ist wiederum in einer Fassung 14 angeordnet und beispielsweise in dieser eingeschraubt. Durch die Halterung 10 ist damit eine gezielte Wärmeableitung möglich.

Das Bezugszeichen 20 bezieht sich auf ein weiteres Kühlsystem bzw. eine Kühleinrichtung, welche wiederum die Fassung 14 umgibt.

Figur 3 zeigt eine weitere Ausführungsform eines erfindungsgemäßen Leuchtelements.

Im Unterschied zu der in Figur 2 gezeigten Ausführungsform sind hier die beiden Anschlüsse 4 und 6 in die Halterung 10 integriert und die elektrische Energie wird hier über die Fassung 14 zugeführt. Zu diesem Zweck ist es möglich, dass die Fassung selbst zweigeteilt ist bzw. die linke und die rechte Seite voneinander elektrisch isoliert sind.

Die Bezugszeichen 22 und 24 beziehen sich auch hier auf die elektrischen Verbindungen. Die Kontakte 4 und 6 können hier aus einem elektrisch leitenden Kunststoff bestehen, der, wie oben erwähnt, von der Fassung 14 versorgt wird.

Figur 4 zeigt eine weitere Ausführungsform eines erfindungsgemäßen Leuchtelements 1. Hier ist eine Vielzahl von Lichtquellen 2 in einer Reihe angeordnet. Die jeweiligen Halterungen 10 weisen hier Außenwandungen 10a, 10b auf, die jeweils komplementär zueinander ausgebildet sind, wobei auf diese Weise eine bestimmte Verlegetechnik möglich ist. Auf diese Weise wird eine flächige Ausführung eines Leuchtelements 1 erreicht.

Die Kontaktierung kann hier wiederum über die elektrischen Verbindungen 22 und 24 erfolgen. Dabei sind wie oben erwähnt, die Leiterbahnen aufgedruckt, aufgepresst, laminiert oder in ähnlicher Weise aufgebracht. Auch wäre es möglich, dass die Kontaktierung der Lichtquellen direkt über die Außenwandungen 10a, 10b erfolgt.

Die Erfindung erlaubt es, speziell für den LED-Einsatz zugeschnittene Halterungen zu gestalten. Diese steigern die Lichtausbeute durch gezielte Wärmeabfuhr, ermöglichen kleinere Bauformen durch an die Umgebungskontur angepasste Halterungen und schaffen durch die integrierte Anschlusstechnik Mehrwert in Bezug auf die Handhabung und Kostenreduktion. Genauer kann die komplette Halterung einschließlich des Einbaus der LED in einem kombinierten Spritzprozess durchgeführt werden.

Sämtliche in den Anmeldungsunterlagen offenbarten Merkmale werden als erfindungswesentlich beansprucht, sofern sie einzeln oder in Kombination gegenüber dem Stand der Technik neu sind.

### Bezugszeichenliste

- 1: Leuchtelement
- 2: Lichtquelle
- 2a: Bereich der Lichtquelle
- 4: Anschluss
- 6: Anschluss
- 10: Halterung
- 10a: Außenwandung
- 10b: Außenwandung
- 100: Leuchtelement (Stand der Technik)
- 102: Lichtquelle (Stand der Technik)
- 104: Anschluss (Stand der Technik)
- 106: Anschluss (Stand der Technik)
- 108: elektrische Verbindung
- 109: elektrische Verbindung
- 110: Halterung (Stand der Technik)
- 114: Fassung bzw. Sockel (Stand der Technik)

## Patentansprüche

1. Leuchtelement (1) mit wenigstens einer Lichtquelle (2), wenigstens zwei Anschlüssen (4, 6), um die Lichtquelle mit elektrischem Strom zu versorgen und mit einer Halterung (10) zur Aufnahme der Lichtquelle (2), wobei die Lichtquelle (2) einen wärmeerzeugenden Abschnitt (2a) aufweist und die Halterung (10) diesen wärmeerzeugenden Abschnitt (2a) kontaktiert, wobei die Halterung (10) aus einem thermisch leitenden Kunststoff besteht;
**dadurch gekennzeichnet, dass** die Halterung (10) derart gestaltet ist, dass sie die von der Lichtquelle (2) erzeugte Wärme wenigstens teilweise in einer bevorzugten Wärmeleitrichtung seitlich nach außen abführt und dass das Leuchtelement (1) eine Fassung (14) aufweist, welche die Halterung (10) umgibt.

2. Leuchtelement nach Anspruch 1,
**dadurch gekennzeichnet,**
**dass** die Lichtquelle (2) eine Leuchtdiode (LED) ist.

3. Leuchtelement (1) nach wenigstens einem der vorangegangen Ansprüche,
**dadurch gekennzeichnet,**
**dass** die Halterung (10) die Lichtquelle (2) in einer Umfangsrichtung vollständig umgibt.

4. Leuchtelement (1) nach wenigstens einem der vorangegangen Ansprüche,
**dadurch gekennzeichnet,**
**dass** wenigstens ein Anschluss (4,6) einen elektrisch leitenden Kunststoff aufweist.

5. Leuchtelement (1) nach wenigstens einem der vorangegangen Ansprüche,
**dadurch gekennzeichnet,**
**dass** die Halterung (10) wenigstens teilweise aus einem elektrisch leitenden Kunststoff besteht.

6. Leuchtelement (1) nach wenigstens einem der vorangegangen Ansprüche,
**dadurch gekennzeichnet,**
**dass** das Leuchtelement eine weitere Kühleinrichtung (20) aufweist, welche die Halterung (10) umgibt.

7. Leuchtelement (1) nach wenigstens einem der vorangegangen Ansprüche,
**dadurch gekennzeichnet,**
**dass** das Leuchtelement (1) aufgedruckte Leiterbahnen aufweist.

8. Leuchtelement (1) nach wenigstens einem der vorangegangen Ansprüche,
**dadurch gekennzeichnet,**
**dass** das Leuchtelement (1) eine Vielzahl von Lichtquellen (2) aufweist.

9. Leuchtelement (1) nach wenigstens einem der vorangegangen Ansprüche,
**dadurch gekennzeichnet,**
**dass** das Leuchtelement (2) eine Vielzahl von Halterungen (10) aufweist, die an ihren Außenwandungen (10a, 10b) zusammenfügbar sind, wobei jeweils eine erste Außenwandung (10a) ein erstes Profil und jeweils eine zweite Außenwandung (10b) ein zweites Profil aufweist und das erste Profil und das zweite Profil komplementär zueinander ausgebildet sind.

10. Halterung für eine Lichtquelle (2), mit einer Aufnahmeausnehmung zur Aufnahme eines wärmeerzeugenden Abschnitts (2a) der Lichtquelle (2), wobei die Halterung (10) aus einem thermisch leitenden Kunststoff besteht, **dadurch gekennzeichnet, dass** die Halterung (10) derart gestaltet ist, dass sie die von der Lichtquelle (2) erzeugte Wärme wenigstens teilweise in einer bevorzugten Wärmeleitrichtung seitlich nach außen abführt und dass die Halterung von einer Fassung umgeben wird.

## Claims

1. A lighting element (1) comprising at least one light source (2), at least two connections (4, 6) to supply electric current to the light source and a fixture (10) to receive the light source (2) wherein the light source (2) comprises a heat-generating section (2a) and the fixture (10) contacts this heat-generating section (2a) wherein the fixture (10) consists of a thermally conductive plastic; **characterized in that** the fixture (10) is configured such that it dissipates the heat generated by the light source (2) at least in part in a preferred direction of heat conduction laterally outward and wherein the lighting element comprises a socket (14) surrounding the fixture (10).

2. The lighting element (1) according to claim 1, **characterised in that** the light source (2) is a light-emitting diode (LED).

3. The lighting element (1) according to at least one of the preceding claims, **characterised in that** the fixture (10) surrounds the light source (2) entirely in a peripheral direction.

4. The lighting element (1) according to at least one of the preceding claims, **characterised in that** at least one connection (4, 6) comprises an electrically conductive plastic.

5. The lighting element (1) according to at least one of the preceding claims, **characterised in that** the fixture (10) consists of an electrically conductive plastic at least in part.

6. The lighting element (1) according to at least one of the preceding claims, **characterised in that** the lighting element comprises another cooling device (20) surrounding the fixture (10).

7. The lighting element (1) according to at least one of the preceding claims, **characterised in that** the lighting element (1) comprises printed conductive tracks.

8. The lighting element (1) according to at least one of the preceding claims, **characterised in that** the lighting element (1) comprises a plurality of light sources (2).

9. The lighting element (1) according to at least one of the preceding claims, **characterised in that** the lighting element (2) comprises a plurality of fixtures (10) which can be joined together at their outer walls (10a, 10b) wherein one first outer wall (10a) each comprises a first profile and one second outer wall (10b) each comprises a second profile and the first profile and the second profile are configured to complement one another.

10. A fixture for a light source (2) comprising a receiving recess to receive a heat-generating section (2a) of the light source (2) wherein the fixture (10) consists of a thermally conductive plastic, **characterized in that** the fixture (10) is configured such that it dissipates the heat generated by the light source (2) at least in part in a preferred direction of heat conduction laterally outward and wherein the lighting element comprises a socket surrounding the fixture.

## Revendications

1. Elément lumineux (1) comprenant au moins une source de lumière (2), au moins deux bornes (4, 6) afin d'alimenter ladite source de lumière en courant électrique ainsi qu'un support (10) de réception de la source de lumière (2), ladite source de lumière (2) présentant une portion (2a) génératrice de chaleur et ledit support (10) contactant cette portion (2a) génératrice de chaleur, ledit support (10) étant réalisé dans une matière plastique thermiquement conductrice, **caractérisé par le fait que** le support (10) est conçu de manière à ce qu'il évacue la chaleur produite par la source de lumière (2) au moins en partie latéralement vers l'extérieur dans une direction préférée de conduction de chaleur et que ledit élément lumineux (1) présente une douille (14) qui entoure le support (10).

2. Elément lumineux selon la revendication 1, **caractérisé par le fait que** ladite source de lumière (2) est une diode électroluminescente (DEL).

3. Elément lumineux (1) selon l'une au moins des revendications précédentes, **caractérisé par le fait que** ledit support (10) entoure la source de lumière (2) complètement dans une direction circonférentielle.

4. Elément lumineux (1) selon l'une au moins des revendications précédentes, **caractérisé par le fait qu'**au moins une borne (4, 6) présente une matière plastique électroconductrice.

5. Elément lumineux (1) selon l'une au moins des revendications précédentes, **caractérisé par le fait que** ledit support (10) est réalisé au moins en partie dans une matière plastique électroconductrice.

6. Elément lumineux (1) selon l'une au moins des revendications précédentes, **caractérisé par le fait que** ledit élément lumineux présente un autre dispositif de refroidissement (20) qui entoure ledit support (10).

7. Elément lumineux (1) selon l'une au moins des revendications précédentes, **caractérisé par le fait que** ledit élément lumineux (1) présente des pistes conductrices imprimées.

8. Elément lumineux (1) selon l'une au moins des revendications précédentes, **caractérisé par le fait que** ledit élément lumineux (1) présente une pluralité de sources de lumière (2).

9. Elément lumineux (1) selon l'une au moins des revendications précédentes, **caractérisé par le fait que** ledit élément lumineux (2) présente une pluralité de supports (10) qui sont aptes à être assemblés sur leurs parois extérieures (10a, 10b), respectivement une première paroi extérieure (10a) présentant un premier profil et respectivement une deuxième paroi extérieure (10b) présentant un deuxième profil et ledit premier profil et ledit deuxième profil étant réalisés de façon complémentaire l'un de l'autre.

10. Support pour une source de lumière (2), comprenant un évidement de réception destiné à recevoir une portion (2a) génératrice de chaleur de la source de lumière (2), le support (10) étant réalisé dans une matière plastique thermiquement conductrice, **caractérisé par le fait que** le support (10) est conçu de manière à ce qu'il évacue la chaleur produite par la source de lumière (2) au moins en partie latéralement vers l'extérieur dans une direction préférée de conduction de chaleur et que ledit support est entouré d'une douille.
